(19) Europäisches Patentamt / European Patent Office / Office européen des brevets

(11) **EP 3 258 276 A1**

(12) **EUROPEAN PATENT APPLICATION**

(43) Date of publication:
20.12.2017 Bulletin 2017/51

(51) Int Cl.:
*G01R 21/00* (2006.01)     *H02J 3/18* (2006.01)

(21) Application number: 17171755.6

(22) Date of filing: 18.05.2017

| | |
|---|---|
| (84) Designated Contracting States:<br>AL AT BE BG CH CY CZ DE DK EE ES FI FR GB<br>GR HR HU IE IS IT LI LT LU LV MC MK MT NL NO<br>PL PT RO RS SE SI SK SM TR<br>Designated Extension States:<br>**BA ME**<br>Designated Validation States:<br>**MA MD**<br><br>(30) Priority: 07.06.2016 KR 20160070213 | (71) Applicant: **LSIS Co., Ltd.**<br>**Gyeonggi-do 14119 (KR)**<br><br>(72) Inventor: **CHOI, Yong-Kil**<br>**14118 Gyeonggi-do (KR)**<br><br>(74) Representative: **Zacco Sweden AB**<br>**P.O. Box 5581**<br>**114 85 Stockholm (SE)** |

(54) **DEVICE FOR MEASURING LOSS IN REACTIVE POWER COMPENSATION SYSTEM**

(57) The present disclosure relates to a device for measuring a loss in a reactive power compensation system to compensate reactive power, which includes at least one load connected to a receiving end, a reactive power compensation unit connected to the receiving end and comprising at least one device, at least one detection unit provided at the at least one device and detecting a voltage, a phase of a voltage, current, and a phase of current, a measurement unit measuring voltage data, current data, and a phase angle based on the voltage, the phase of a voltage, the current, and the phase of current detected by the at least one detection unit, and a loss calculation unit calculating loss power of the at least one device based on the measured voltage data, current data and phase angle.

FIG. 1

EP 3 258 276 A1

## Description

## BACKGROUND

### 1. Technical Field

The present disclosure relates to a device for measuring a loss in a reactive power compensation system.

### 2. Description of the Related Art

When power is supplied to a receiving end connected to a load, the power is not all used by the load. In other words, the power is not all used as active power by the load and part of the power is lost as reactive power, not contributing to a real work.

To minimize or compensate the reactive power, a reactive power compensation system is employed.

The reactive power compensation system adjusts a phase of a voltage or a phase of current and thus the reactive power may be minimized.

Meanwhile, there may be a loss due to constituent devices of the reactive power compensation system.

However, it is a problem that it is difficult to identify how much loss has occurred by various devices configured in a conventional reactive power compensation system.

Accordingly, from the perspective of a purchaser of the reactive power compensation system, it is a problem that it is difficult to determine the economical efficiency on the purchase of the reactive power compensation system. Furthermore, it is impossible to continuously identify a loss due to the reactive power compensation system and prepare a countermeasure corresponding to the identified loss.

Also, from the perspective of a manufacturer of the reactive power compensation system, since the loss of the reactive power compensation system cannot be identified, it is difficult to answer purchaser's inquiries regarding the loss and furthermore it is difficult to advertise reliability of the system to the purchasers.

In addition, in order to reflect the amount of maintenance/repair and a loss of the reactive power compensation system to design, the loss of the reactive power compensation system should be identified. Nevertheless, it has not been possible to identify the loss of the reactive power compensation system according to the related art.

Accordingly, since a loss of the reactive power compensation system cannot be identified, accurate evaluation about the entire system including the reactive power compensation system is not possible and the loss cannot be reflected in the design of a next system.

## SUMMARY

It is an object of the present disclosure to address the above-described problems and other problems.

It is another object of the present disclosure to provide a device for measuring a loss in a reactive power compensation system, by which a loss of various devices included in a reactive power compensation system may be identified.

Objects of the present disclosure are not limited to the above-described objects and other objects and advantages can be appreciated by those skilled in the art from the following descriptions. Further, it will be easily appreciated that the objects and advantages of the present disclosure can be practiced by means recited in the appended claims and a combination thereof.

In accordance with one aspect of the present disclosure, there is provided a device for measuring a loss in a reactive power compensation system to compensate reactive power, which includes at least one load, a reactive power compensation unit, at least one detection unit, a measurement unit, and a loss calculation unit.

The at least one load may be connected to a receiving end.

The reactive power compensation unit may be connected to the receiving end and may include at least one device.

The at least one detection unit may be provided at the at least one device and may detect a voltage, a phase of a voltage, current, and a phase of current.

The measurement unit may measure voltage data, current data, and a phase angle based on the voltage, the phase of a voltage, the current, and the phase of current detected by the at least one detection unit.

The loss calculation unit may calculate loss power of the at least one device based on the measured voltage data, current data and phase angle.

## BRIEF DESCRIPTION OF DRAWINGS

FIG. 1 illustrates a device for measuring a loss in a reactive power compensation system according to an embodiment of the present disclosure.
FIG. 2 is a flowchart of a compensation method of a reactive power compensation system.

## DETAILED DESCRIPTION

The above objects, features and advantages will become apparent from the detailed description with reference to the accompanying drawings. Embodiments are described in sufficient detail to enable those skilled in the art in the art to easily practice the technical idea of the present disclosure. Detailed descriptions of well-known functions or configurations may be omitted in order not to unnecessarily obscure the gist of the present disclosure. Hereinafter, embodiments of the present disclosure will be described in detail with reference to the accompanying drawings. Throughout the drawings, like reference numerals refer to like elements.

As the inventive concept allows for various changes and numerous embodiments, particular embodiments will be illustrated in the drawings and described in detail in the written description, wherein like reference numerals in the drawings denote like elements, and thus their description will not be repeated. The suffix "module" and "unit" for components, which are used in the description below, are assigned and mixed in consideration of only the easiness in writing the specification. That is, the suffix itself does not have different meanings or roles. However, this is not intended to limit the present inventive concept to particular modes of practice, and it is to be appreciated that all changes, equivalents, and substitutes that do not depart from the spirit and technical scope of the present inventive concept are encompassed in the present inventive concept. In the description of the present inventive concept, certain detailed explanations of related art are omitted when it is deemed that they may unnecessarily obscure the essence of the inventive concept.

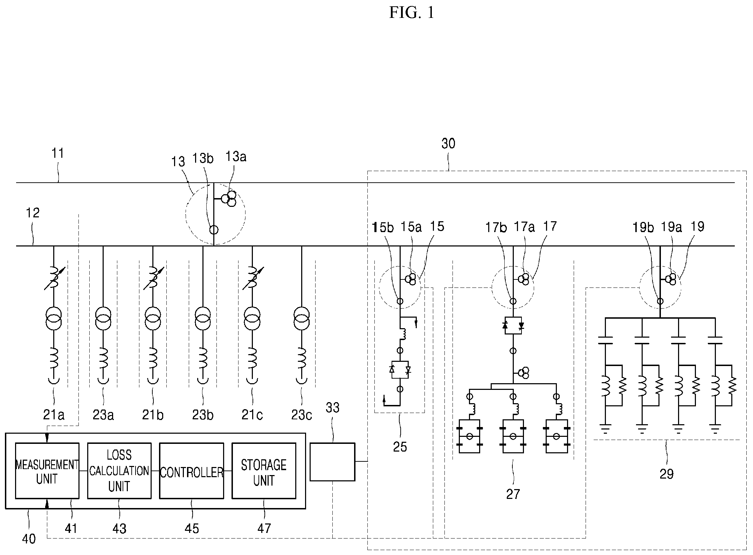

FIG. 1 illustrates a device for measuring a loss in a reactive power compensation system according to an embodiment of the present disclosure.

Referring to FIG. 1, the device for measuring a loss in a reactive power compensation system according to the present embodiment may include a reactive power compensation unit 30 and a control system 40.

A plurality of loads 21a, 21b, 21c, 23a, 23b, and 23c may be connected to a receiving end 11. In detail, a branch line 12 may be branched from the receiving end 11, and the loads 21a, 21b, 21c, 23a, 23b, and 23c may be connected to the branch line 12.

Although FIG. 1 illustrates that the branch line 12 is connected to the receiving end 11, the loads 21a, 21b, 21c, 23a, 23b, and 23c may be directly connected to the receiving end 11 without the branch line 12.

The loads 21a, 21b, 21c, 23a, 23b, and 23c may be connected to a system other than the receiving end 11. The system may be an AC system, a DC system, or a HVDC system. However, the present disclosure is not limited thereto.

The loads 21a, 21b, 21c, 23a, 23b, and 23c may be loads provided in ironworks, for example, arc furnaces 21a, 21b, and 21c or smelting furnaces 23a, 23b, and 23c. However, the present disclosure is not limited thereto.

The reactive power compensation unit 30 may be connected parallel to the loads 21a, 21b, 21c, 23a, 23b, and 23c and commonly with the loads 21a, 21b, 21c, 23a, 23b, and 23c to the branch line 12 or the receiving end 11, but the present disclosure is not limited thereto. Accordingly, power supplied to the receiving end 11 may be supplied not only to the loads 21a, 21b, 21c, 23a, 23b, and 23c, but also to the reactive power compensation unit 30.

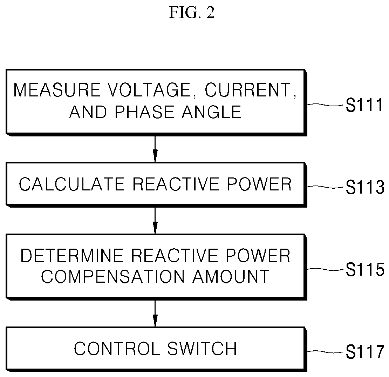

The reactive power compensation unit 30, as illustrated in FIG. 2, may include a Thyristor-controlled reactor (TCR) 25, a Thyristor-switched capacitor (TSC) 27, and a harmonic filter unit 29.

The TCR 25 may include a reactor and a thyristor switch. The number or arrangement of reactors may be implemented by various methods.

The TSC 27 may include a capacitor and a thyristor switch. The number or arrangement of capacitors may be implemented by various methods.

The harmonic filter unit 29 may include a plurality of filters. Each filter may include a resistor, a capacitor, and an inductor. Although the resistor and the inductor may be connected in parallel, but the present disclosure is not limited thereto.

Both the TCR 25 and the TSC 27 may not be necessarily provided. Only one of the TCR 25 and the TSC 27 may be provided, but the present disclosure is not limited thereto.

Although not illustrated, a fixed compensation unit may be further provided in addition to the TCR 25 or the TSC 27. The fixed compensation unit may be a fixed capacitor.

The reactive power compensation unit 30 may control the Thyristor switch provided therein to compensate the reactive power.

The above configuration is described below in detail.

As illustrated in FIG. 2, a voltage, current, and a phase angle may be measured (S111).

For example, a voltage, current, and a phase angle may be detected by a first detection unit 13 and then measured by a measurement unit 41 provided in the control system 40. In detail, a voltage transformer 13a of the first detection unit 13 may detect a voltage and a phase of a voltage applied to the branch line 12, and a current transformer 13b of the first detection unit 13 may detect current and a phase of current applied to the branch line 12.

The voltage and the phase of a voltage, and the current and the phase of current, detected by the first detection unit 13 are provided to the measurement unit 41. Accordingly, the measurement unit 41 may measure voltage data, current data, and a phase angle based on the voltage, the phase of a voltage, the current, and the phase of current.

The phase angle may be calculated based on the phase of a voltage and the phase of current. For example, when a phase of current is ahead of a phase of a voltage, it may be referred to as leading, and when a phase of a voltage is ahead of a phase of current, it may be referred to as lagging.

For example, when a phase angle in leading is expressed by a positive phase angle, a phase angle in lagging may be expressed by a negative phase angle.

When the loads 21a, 21b, 21c, 23a, 23b, and 23c are directly connected to the receiving end 11, a voltage and a phase of a voltage on a line of the receiving end 11 is detected by the voltage transformer 13a of the first detection unit 13, and current and a phase of current flowing in the line of the receiving end 11 may be detected by the current transformer 13b of the first detection unit 13.

The controller 45 may calculate reactive power based on the measured voltage, current, and phase angle (S113). Next, the controller 45 may calculate a reactive power compensation amount based on the calculated reactive power (S115).

The reactive power compensation amount may be calculated by a mathematical expression "Power Factor Compensation Target Value - Current Power Factor".

The power factor may indicate a ratio of active power and apparent power. The apparent power may indicate power supplied to the receiving end 11, and the active power may be power obtained by excluding the reactive power from the apparent power. Accordingly, as the power factor is improved by the power factor compensation, the active power may be increased and thus power loss may be reduced and the power may be efficiently used.

According to whether it is leading reactive power or lagging reactive power, the reactive power compensation amount may be calculated to be +Q or -Q.

The leading reactive power may be reactive power when the phase of current is ahead of the phase of a voltage, and the lagging reactive power may be reactive power when the phase of a voltage is ahead of the phase of current.

The controller 45 may control the Thyristor switch provided in the reactive power compensation unit 30 according to the reactive power compensation amount +Q or -Q (S117).

As such, since the reactive power is compensated under the control of the Thyristor switch, the reactive power of the power supplied to the branch line 12 is minimized and thus the corresponding power may be used for the loads 21a, 21b, 21c, 23a, 23b, and 23c.

The reactive power compensation unit 30 may include a plurality of devices. For example, the reactive power compensation unit 30 may include the TCR 25, the TSC 27, and the harmonic filter unit 29. The TCR 25, the TSC 27, and the harmonic filter unit 29 may be main devices.

In addition, the reactive power compensation unit 30 may include a battery, an emergency generator, or an air conditioner, as ancillary devices, but the present disclosure is not limited thereto.

Since the devices of the reactive power compensation unit 30 also operate, a loss is generated. However, conventionally, since the loss generated by the devices of the reactive power compensation unit 30 are not identified, various subsequent operations are not available.

According to the present disclosure, since the loss of each of the devices of the reactive power compensation unit 30 can be identified, various evaluations or subsequent actions may be taken based on the overall loss of the reactive power compensation unit 30 including the loss of the devices.

To measure the loss of the reactive power compensation unit 30, a plurality of detection units may be provided.

For example, as the first detection unit 13 is provided between the receiving end 11 and the branch line 12, a voltage, a phase of a voltage, current, and a phase of current on the branch line 12 may be detected.

For example, as a second detection unit 15 is provided at an input side of the TCR 25 of the reactive power compensation unit 30, a voltage, a phase of a voltage, current, and a phase of current on an input side of the TCR 25 may be detected.

Current may flow into the TCR 25, or may flow out from the TCR 25 during compensation.

For example, as a third detection unit 17 is provided at an input side of the TSC 27 of the reactive power compensation unit 30, the voltage, the phase of a voltage, the current, and the phase of current at the input side of the TSC 27 may be detected. Current may flow into the TSC 27, or may flow out from the TCR 25 during compensation.

For example, as a fourth detection unit 19 is provided at an input side of the harmonic filter unit 29 of the reactive power compensation unit 30, the voltage, the phase of a voltage, the current, and the phase of current at the input side of the harmonic filter unit 29 may be detected.

For example, as a fifth detection unit 33 is provided at an input side of each ancillary device of the reactive power compensation unit 30, the voltage, the phase of a voltage, the current, and the phase of current at the input side of each ancillary device may be detected.

The ancillary device may be, for example, a battery, an emergency generator, or an air conditioner, but the present disclosure is not limited thereto.

The first to fifth detection units 13, 15, 17, 19, and 33 may respectively include the voltage transformers 13a, 15a, 17a, and 19a and the current transformers 13b, 15b, 17b, and 19b.

The control system 40 may include the measurement unit 41, a loss calculation unit 43, the controller 45, and a storage unit 47.

The controller 45 may manage and control the overall system including the reactive power compensation unit 30.

The measurement unit 41, the loss calculation unit 43, and the storage unit 47 included in the control system 40 may perform specific functions under the control of the controller 45.

The measurement unit 41 may receive, for example, inputs of the voltage, the phase of a voltage, the current, and the phase of current detected by the first to fifth detection units 13, 15, 17, 19, and 33, and may measure voltage data, current data, and a phase angle of a certain device based on the voltage, the phase of a voltage, the current, and the phase of current.

The voltage, the phase of a voltage, the current, and the phase of current detected by the first to fifth detection units 13, 15, 17, 19, and 33 may be analog signals.

The measurement unit 41 may convert the voltage, the phase of a voltage, the current, and the phase of current that are detected analog signal, to digital signals, amplify and/or modulate the converted signals, and measure the voltage data, the current data, and the phase angle.

The loss calculation unit 43 may calculate supply power supplied via the receiving end 11 based on the voltage data, the current data, and the phase angle detected by the first detection unit 13 and measured by the measurement unit 41.

The loss calculation unit 43 may calculate loss power of each device based on the voltage data, the current data, and the phase angle measured by the measurement unit 41.

The loss power of each device may be calculated by Equation 1 below.

[Equation 1]

$$P_{loss} = VIt$$

In Equation 1, "$P_{loss}$" may denote loss power, "V" may denote a voltage measured at a specific device, "I" may denote current measured at the specific device, and "t" may denote time.

The loss power may be cumulatively calculated in units of time. For example, when the loss power is cumulatively calculated by one hour, the loss power may be cumulatively calculated twenty-four (24) times per day and thus an average amount of the 24-times cumulatively calculated loss power may be calculated. The 24-times cumulatively calculated loss power and the daily average amount may be stored in the storage unit 47.

Accordingly, the loss of the reactive power compensation unit 30 may be easily identified through the loss power calculated for each hour or the daily average amount calculated per day. Accordingly, since the identification of a loss is not a one-time performance, the loss may be identified continuously and in real time as long as the reactive power compensation unit 30 operates.

Accordingly, from the perspective of a purchaser or an operator of the reactive power compensation unit 30, it is possible to determine the economical efficiency according to the loss.

For example, the loss calculation unit 43 may determine the economical efficiency of the reactive power compensation unit 30 by comparing the loss power consumed by the reactive power compensation unit 30 and compensation power for compensating the reactive power. Accordingly, a periodical electricity rate reduction effect of the reactive power compensation unit 30 may be obtained.

The economical efficiency may be determined by the controller 45 instead of the loss calculation unit 43.

When a product production amount increases according to a load operation amount, an effect of reactive power compensation occurs in proportion thereto. The economical effect of the reactive power compensation may be increased particularly in the summer time when the electricity rate is high.

Furthermore, from the perspective of a purchaser or an operator of the reactive power compensation unit 30, a degree of deterioration of the reactive power compensation unit 30 and a replacement cycle thereof may be identified by recognizing an increase in the loss of the reactive power compensation unit 30. Furthermore, information about the loss obtained with respect to the reactive power compensation unit 30 may be reflected to the overall system or in the design of a next new system.

From the perspective of a manufacturer who sold the reactive power compensation unit 30, the reactive power compensation unit 30 may be sold more by advertising that not only the reactive power compensation of the reactive power compensation unit 30 may be possible, but also the loss of the reactive power compensation unit 30 may be identified.

In addition, as the number of loads in use among the loads 21a, 21b, 21c, 23a, 23b, and 23c may vary according to time, and as the number of the loads 21a, 21b, 21c, 23a, 23b, and 23c vary, the loss generated in the reactive power compensation unit 30 may vary. However, since the loss of the reactive power compensation unit 30 that varies according to the number of the loads 21a, 21b, 21c, 23a, 23b, and 23c in use may be measured by the device for measuring a loss of the reactive power compensation unit 30 according to the present disclosure, an evaluation or a countermeasure thereto may be easily found.

As described above, the effects of the device for measuring a loss in a reactive power compensation system according to the present disclosure are as follows.

According to at least one of the embodiments of the present disclosure, the loss of the reactive power compensation system may be easily identified and the loss may be identified continuously and in real time.

According to at least one of the embodiments of the present disclosure, from the perspective of a purchaser or an operator of the reactive power compensation unit, the economical efficiency according to the loss may be determined, and a degree of deterioration of the reactive power compensation unit and a replacement cycle thereof may be identified by recognizing an increase in the loss of the reactive power compensation unit 30.

According to at least one of the embodiments of the present disclosure, from the perspective of a manufacturer who sold the reactive power compensation unit, the reactive power compensation unit may be sold more by advertising that not only the reactive power compensation of the reactive power compensation unit 30 may be possible, but also the loss of the reactive power compensation unit 30 may be identified.

According to at least one of the embodiments of the present disclosure, since the loss of the reactive power compensation unit that varies according to the number of the loads in use may be measured by the device for measuring a loss of the reactive power compensation unit according to the present disclosure, an evaluation or a countermeasure thereto may be easily found.

The present disclosure described above may be variously substituted, altered, and modified by those skilled in the art to which the present inventive concept pertains without departing from the scope and sprit of the present disclosure. Therefore, the present disclosure is not limited to the above-mentioned exemplary embodiments and the accompanying drawings.

**Claims**

1. A device for measuring a loss in a reactive power compensation system to compensate reactive power, the device comprising:

    at least one load (21a, 21b, 21c, 23a, 23b, 23c) connected to a receiving end (11);
    a reactive power compensation unit (30) connected to the receiving end (11) and comprising at least one device;
    at least one detection unit (13, 15, 17, 19, 33) provided at the at least one device and detecting a voltage, a phase of a voltage, current, and a phase of current;
    a measurement unit (41) measuring voltage data, current data, and a phase angle based on the voltage, the phase of a voltage, the current, and the phase of current detected by the at least one detection unit; and
    a loss calculation unit (43) calculating loss power of the at least one device based on the measured voltage data, current data and phase angle.

2. The device of claim 1, wherein the at least one device comprises at least one main device and at least one ancillary device.

3. The device of claim 2, wherein the at least one main device comprises at least one of a Thyristor-controlled reactor (TCR), a Thyristor-switched capacitor (TSC), and a harmonic filter unit.

4. The device of claim 3, wherein the at least one detection unit comprises:

    a first detection unit provided at an input side of the TCR;
    a second detection unit provided at an input side of the TSC; and
    a third detection unit provided at an input side of the harmonic filter unit.

5. The device of claim 2, wherein the at least one ancillary device comprises at least one of a battery, an emergency generator, and an air conditioner.

6. The device of claim 5, wherein the at least one detection unit (13, 15, 17, 19, 33) comprises:

    a fourth detection unit provided at an input side of the battery;
    a fifth detection unit provided at an input side of the emergency generator; and
    a sixth detection unit provided at an input side of the air conditioner.

7. The device of claim 1, further comprising another detection unit that is provided between the receiving end (11) and the at least one load (21a, 21b, 21c, 23a, 23b, 23c).

8. The device of claim 1, further comprising a storage unit (47) that stores loss power in units of hours and a daily average amount calculated by the loss calculation unit(43).

9. The device of claim 1, wherein the loss calculation unit(43) determines economic efficiency of the reactive power compensation unit by comparing loss power consumed by the reactive power compensation unit(30) and compensation power for compensating reactive power.

FIG. 1

FIG. 2

```
┌─────────────────────────────────┐
│  MEASURE VOLTAGE, CURRENT,      │──S111
│      AND PHASE ANGLE            │
└─────────────────────────────────┘
                 │
                 ▼
┌─────────────────────────────────┐
│    CALCULATE REACTIVE POWER     │──S113
└─────────────────────────────────┘
                 │
                 ▼
┌─────────────────────────────────┐
│   DETERMINE REACTIVE POWER      │──S115
│     COMPENSATION AMOUNT         │
└─────────────────────────────────┘
                 │
                 ▼
┌─────────────────────────────────┐
│        CONTROL SWITCH           │──S117
└─────────────────────────────────┘
```

Europäisches
Patentamt

European
Patent Office

Office européen
des brevets

# EUROPEAN SEARCH REPORT

Application Number

EP 17 17 1755

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 92/15929 A1 (UNIV WASHINGTON [US]) 17 September 1992 (1992-09-17) * page 2, lines 10-31; figure 1 * * page 9, lines 18-29 * | 1-9 | INV. G01R21/00 H02J3/18 |
| X | EP 2 945 245 A1 (SIEMENS AG [DE]) 18 November 2015 (2015-11-18) | 1-3 | |
| A | * paragraphs [0002], [0004], [0006], [0019], [0044]; claims 1,24 * | 6-9 | |
| X | EP 1 863 146 A1 (HATCH LTD [CA]) 5 December 2007 (2007-12-05) * paragraphs [0003] - [0006], [0015] - [0017], [0031]; claim 1; figures 1,3,5,6 * | 1-9 | |
| X | US 4 001 671 A (GYUGYI LASZLO ET AL) 4 January 1977 (1977-01-04) | 1 | |
| A | * column 4, lines 45-49; claims 1,4; figures 3A-3E, 4-15 * | 2-9 | |

TECHNICAL FIELDS
SEARCHED (IPC)

H02J
G01R

The present search report has been drawn up for all claims

| Place of search | Date of completion of the search | Examiner |
|---|---|---|
| Munich | 25 October 2017 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EP 3 258 276 A1

### ANNEX TO THE EUROPEAN SEARCH REPORT
### ON EUROPEAN PATENT APPLICATION NO.

EP 17 17 1755

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2017

| Patent document cited in search report | | Publication date | Patent family member(s) | | Publication date |
|---|---|---|---|---|---|
| WO 9215929 | A1 | 17-09-1992 | AT | 141422 T | 15-08-1996 |
| | | | CA | 2062452 A1 | 08-09-1992 |
| | | | DE | 69212742 D1 | 19-09-1996 |
| | | | DE | 69212742 T2 | 09-01-1997 |
| | | | EP | 0528016 A1 | 24-02-1993 |
| | | | WO | 9215929 A1 | 17-09-1992 |
| EP 2945245 | A1 | 18-11-2015 | CN | 106463962 A | 22-02-2017 |
| | | | EP | 2945245 A1 | 18-11-2015 |
| | | | KR | 20160145160 A | 19-12-2016 |
| | | | US | 2017085085 A1 | 23-03-2017 |
| | | | WO | 2015172945 A1 | 19-11-2015 |
| EP 1863146 | A1 | 05-12-2007 | CA | 2463130 A1 | 24-04-2003 |
| | | | CN | 1605143 A | 06-04-2005 |
| | | | EP | 1436876 A1 | 14-07-2004 |
| | | | EP | 1863146 A1 | 05-12-2007 |
| | | | US | 2003076075 A1 | 24-04-2003 |
| | | | WO | 03034566 A1 | 24-04-2003 |
| | | | ZA | 200402807 B | 29-06-2005 |
| US 4001671 | A | 04-01-1977 | CA | 1033010 A | 13-06-1978 |
| | | | JP | S5189146 A | 04-08-1976 |
| | | | JP | S5611170 B2 | 12-03-1981 |
| | | | US | 4001671 A | 04-01-1977 |

EPO FORM P0459

For more details about this annex : see Official Journal of the European Patent Office, No. 12/82